# EUROPÄISCHE PATENTSCHRIFT

(11) **EP 4 431 957 B1**
(45) Veröffentlichungstag und Bekanntmachung des Hinweises auf die Patenterteilung: **04.06.2025**
(21) Anmeldenummer: 23215193.6
(22) Anmeldetag: 08.12.2023
(51) Int. Cl.: G01R 31/18, G01R 31/69

(54) **VORRICHTUNG UND VERFAHREN ZUM PRÜFEN EINES AUSSENLEITERKONTAKTS**
APPARATUS AND METHOD FOR TESTING AN OUTER CONDUCTOR CONTACT
DISPOSITIF ET PROCÉDÉ DE TEST DE CONDUCTEUR EXTÉRIEUR D'UN CONTACT

(30) Priorität: 15.03.2023 DE 102023106422
(43) Veröffentlichungstag der Anmeldung: 18.09.2024
(73) Patentinhaber: MD Elektronik GmbH, 84478 Waldkraiburg (DE)
(72) Erfinder: Eben, Johannes, 83024 Rosenheim (DE); Wiebe, Rudolf, 84559 Kraiburg am Inn (DE); Harrer, Helmut, 84478 Waldkraiburg (DE); Kirchisner, Rupert, 84494 Lohkirchen (DE)

(56) Entgegenhaltungen:
- CN-A- 110 376 496
- DE-U1- 202004 019 162
- US-A1- 2019 219 631
- US-A1- 2020 072 890

## Beschreibung

### Technisches Gebiet

Die Erfindung betrifft eine Vorrichtung sowie ein Verfahren zum Prüfen eines Außenleiterkontakts, wobei die Prüfung bevorzugt eine elektrische Prüfung umfasst und das Verfahren bevorzugt automatisiert abläuft.

### Stand der Technik

Bei der Herstellung von Außenleiterkontakten, insbesondere wie sie zur Konfektionierung von Koaxialleitungen eingesetzt werden, kann es vorkommen, dass sich auf Grund von starken Verformungen während des Stanzprozesses Material mit der Oberfläche nicht vollständig ablöst. Dieses Material bildet dann oftmals Späne oder feine Härchen, welche später einen ungewollten Kurzschluss in einem fertig konfektionierten Stecksystem verursachen können. Um solche Kurzschlüsse zu vermeiden, müssen die Späne oder Härchen gefunden und entfernt werden.

Im Stand der Technik werden dazu elektrische Prüfverfahren an den fertig konfektionierten (Koaxial-)Leitungen durchgeführt. Insbesondere wird eine vorgegebene Spannung von zum Beispiel 500 V bei Koaxialleitungen auf den Innenleiterkontakt gelegt, um ein Überschlag, der durch elektrisch leitfähige Fremdkörper zwischen Innen- und Außenleiterkontakt hervorgerufen wird, auf den Außenleiterkontakt zu ermitteln. Da diese Prüfverfahren jedoch erst am Ende der Konfektionierung stattfinden, wird eine fehlerhafte Leitung erst dann als solche erkannt und als Ausschuss deklariert.

Alternativ werden Außenleiterkontakte im Stand der Technik nach ihrem Fertigungsprozess bzw. Montagevorgang an eine Leitung optisch geprüft. Bei den optischen Prüfungen können Fremdbestandteile oder Kurzschlüsse allerdings je nach Lage und Erscheinung nicht zuverlässig detektiert werden.

Relevanter Stand der Technik wird in US 2020/072890 A1 veröffentlicht.

### Beschreibung der Erfindung

Es ist daher eine Aufgabe der vorliegenden Erfindung eine Vorrichtung und ein Verfahren zum effektiven Prüfen von Außenleiterkontakten bereitzustellen, um den Ausschuss zu reduzieren.

Die oben genannte Aufgabe wird durch eine Vorrichtung nach Anspruch 1 und einem Verfahren nach Anspruch 6 gelöst. Weitere vorteilhafte Ausgestaltungsformen der Erfindung lassen sich den Unteransprüchen, der Beschreibung sowie den Zeichnungen entnehmen.

Insbesondere wird die oben genannte Aufgabe gelöst durch eine Vorrichtung zum Prüfen eines Außenleiterkontakts aufweisend eine Führung mit einem Vorschub zum Bereitstellen eines Trägerstreifens mit Außenleiterkontakten an einem Fixierbereich, eine Fixiervorrichtung zum Fixieren eines zu prüfenden Außenleiterkontakts an dem Fixierbereich, und einen Prüfstift, der zumindest teilweise in den Außenleiterkontakt eingeführt werden kann und ein vorbestimmtes elektrisches Feld erzeugt, so dass elektrisch leitfähige Fremdkörper, die sich innerhalb des Außenleiterkontakts befinden, einen Kurzschluss verursachen.

Mit der vorliegenden Vorrichtung ist es möglich auf einfache und zuverlässige Weise Außenleiterkontakte vor der Konfektionierung auf eine Leitung zu prüfen. Durch das Prüfen vor dem Konfektionieren kann ein defekter Außenleiterkontakt erkannt und von der weiteren Bearbeitung bzw. Konfektionierung ausgeschlossen werden. Das spart Zeit und Ressourcen, und reduziert den Ausschuss an konfektionierten Leitungen. Die Prüfung erfolgt bevorzugt im Hinblick auf Fremdkörper, die sich im Inneren des Außenleiters befinden, und die bei einem späteren Einsatz des Außenleiters in einem Steckverbinder zu einem ungewollten Kurzschluss führen. Weiterhin erkennt die vorliegende Vorrichtung Fremdkörper, wie feine metallische Haare oder Späne, die sich teilweise hinter anderen Bauteilen im Außenleiterkontakt, beispielsweise einem Isolator, verstecken und bei einem späteren Einsatz zu einem Kurzschluss führen.

Bevorzugt wird das elektrische Feld durch eine Spannung am Prüfstift im Bereich von 100 - 1000 V, bevorzugter im Bereich von 200 - 900 V, noch bevorzugter im Bereich von 300 - 800 V, und am bevorzugtesten im Bereich von 400 - 700 V, erzeugt. Bei Spannungen über 1000 V sind besondere Sicherungsmaßnahmen erforderlich, wodurch die Vorrichtung komplizierter aufgebaut sein muss. Daher ist es wünschenswert in einem Spannungsbereich bis 1000 V zu prüfen. Darüber hinaus haben Tests gezeigt, dass je geringer die Spannung ist, die zum Prüfen verwendet wird, desto weniger Falschpositive ergeben sich.

Bevorzugt ist ein maximaler Durchmesser des Prüfstifts in Bezug auf den Außenleiterkontakt so gewählt, dass eine Summe aus dem maximalen Durchmesser des Prüfstifts und einer doppelten Mindestluftstrecke kleiner ist als ein Innendurchmesser des Außenleiterkontakts. Befindet sich ein elektrisch leitfähiges Objekt, oder auch der Außenleiterkontakt selbst, im Bereich der Mindestluftstrecke zum Prüfstift, kommt es zum Kurzschluss. Um einen ungewollten Kurzschluss zwischen Außenleiterkontakt und Prüfstift zu vermeiden kann als eine Möglichkeit die genannte Bedingung erfüllt sein. So kann sichergestellt werden, dass lediglich Fremdkörper innerhalb des Außenleiterkontakts und nicht der Außenleiterkontakt selbst zum Kurzschluss führen.

Bevorzugt wird die Mindestluftstrecke tabellarisch bei einem vorbestimmten Verschmutzungsgrad ermittelt. Die Mindestluftstrecken in Abhängigkeit einer angelegten Spannung am Prüfstift sind bekannt und können anhand von Tabellen einfach ermittelt werden. Sollten sich die Prüf- und/oder Einsatzbedingungen für einen Außenleiterkontakt oder Stecker ändern, kann das entsprechend anhand der Tabelleneinträge berücksichtigt werden.

Bevorzugt wird ein Kurzschluss durch Fremdkörper wie zumindest teilweise gelöste Partikel einer Außenleiterkontaktinnenoberfläche ausgelöst. Das hat den Vorteil, dass insbesondere metallische Späne, Fäden und/oder Flitter, die bei der Herstellung der Außenleiterkontaktform auftreten, und die oft noch an der Innenoberfläche des Außenleiterkontakts haften, erkannt werden. Durch die Erkennung kann der betreffende Außenleiterkontakt als Ausschuss markiert werden, und von der weiteren Konfektionierung ausgeschlossen werden, wodurch ein späterer Kurzschluss in einer konfektionierten Leitung verhindert wird.

Die oben genannte Aufgabe wird weiterhin insbesondere gelöst durch ein Verfahren zum Prüfen eines Außenleiterkontakts, wobei das Verfahren die folgenden Schritte aufweist: Bereitstellen eines Außenleiterkontakts an einem Fixierbereich, Fixieren des Außenleiterkontakts an dem Fixierbereich, Einführen eines Prüfstifts zumindest teilweise in den Außenleiterkontakt, wobei der Prüfstift keine Spannung aufweist, Anlegen einer Spannung an dem Prüfstift, und Prüfen, ob ein Kurzschluss zwischen dem Prüfstift und zumindest einem elektrisch leitfähigen Fremdkörper, der sich innerhalb des Außenleiterkontakts befinden kann, stattgefunden hat.

Das vorliegende Verfahren hat den Vorteil, dass es automatisiert umgesetzt werden kann. Weiterhin ist bei dem vorliegenden Verfahren das Handling der Außenleiterkontakte an einem Trägerstreifen einfacher, als das Handling einer bereits konfektionierten Leitung. Wird ein Außenleiterkontakt als Ausschuss erkannt, kann er einfach nach dem Prüfen von dem Trägerstreifen getrennt werden und steht einer nachfolgenden Konfektionierung nicht mehr zur Verfügung. Dadurch wird das Prüfen, und insbesondere auch das nachfolgende Konfektionieren einer Leitung, viel effektiver als mit Verfahren aus dem Stand der Technik.

Bevorzugt findet das Verfahren vor einer Konfektionierung des Außenleiterkontakts auf einer Leitung statt. Das Prüfen der Außenleiterkontakte vor der Konfektionierung auf einer Leitung hat die Vorteile, dass Ausschuss frühzeitig erkannt wird und unnötige Konfektionierungen entfallen. Dieses Vorgehen spart Zeit und Ressourcen.

Bevorzugt wird das Einführen des Prüfstifts bis zum Anschlag an einem Isolator, der innerhalb des Außenleiterkontakts angeordnet ist, durchgeführt. Durch das Einführen des Prüfstifts bis zum Isolator wird der gesamte Bereich, der (später) für einen Kurzschluss (zwischen Innen- und Außenleiterkontakt) relevant ist, überprüft. Der Prüfstift wird jedoch auch nicht weiter als notwendig in den Außenleiterkontakt eingeführt, denn in dem Bereich des Isolators ist jeder Fremdkörper durch den Isolator verdeckt und würde nicht zu einem Kurzschluss führen. Indem erst geprüft wird, nachdem ein Isolator im Außenleiterkontakt angeordnet ist, wird Ausschuss reduziert, bei dem zwar Fremdkörper an der Innenoberfläche des Außenleiterkontakts auftreten, diese jedoch vom Isolator (vollständig) verdeckt sind. Das Prüfverfahren an sich ist unabhängig davon, ob ein Isolator bereits im Außenleiterkontakt angeordnet ist oder nicht.

Bevorzugt wird das Prüfen durch eine elektrische Messung und/oder eine optische Messung durchgeführt. Elektrische und optische Messungen stellen voneinander unabhängige Messverfahren dar. Mit dem Einsatz beider Messverfahren zur gleichen Zeit sind redundante Messungen möglich. Durch redundante Messungen kann sich die Zuverlässigkeit der Messung erhöhen. Optische Messungen können einfacher aufgebaut sein, während elektrische Messungen genauer sein können.

Bevorzugt erfolgt das Fixieren durch Kraft- und/oder Formschluss mit Hilfe einer Fixiervorrichtung. Der Kraft- und/oder Formschluss sind einfache Arten einen zu prüfenden Außenleiterkontakt sicher zu fixieren. Der Formschluss kann direkt auf einen bestimmten Außenleiterkontakt angepasst werden und ein Verrutschen des Außenleiterkontakts ausschließen.

Die folgende Beschreibung von Ausführungsformen erfolgt unter Bezugnahme auf die begleitenden Figuren. Dabei zeigt:
- Fig. 1: eine perspektivische Ansicht einer Ausführungsform einer Anlage zum Prüfen eines Außenleiterkontakts;
- Fig. 2: eine Detailansicht von Fig. 1;
- Fig. 3: die Detailansicht von Fig. 2 mit fixiertem Außenleiter;
- Fig. 4: die Detailansicht von Fig. 3 mit eingeführtem Prüfstift;
- Fig. 5: eine perspektivische Ansicht einer Ausführungsform eines Außenleiterkontakts mit eingeführtem Prüfstift; und
- Fig. 6: eine Querschnittsansicht der Darstellung aus Fig. 5.

Im Folgenden werden bevorzugte Ausführungsformen im Detail mit Bezug auf die beigefügten Figuren beschrieben.

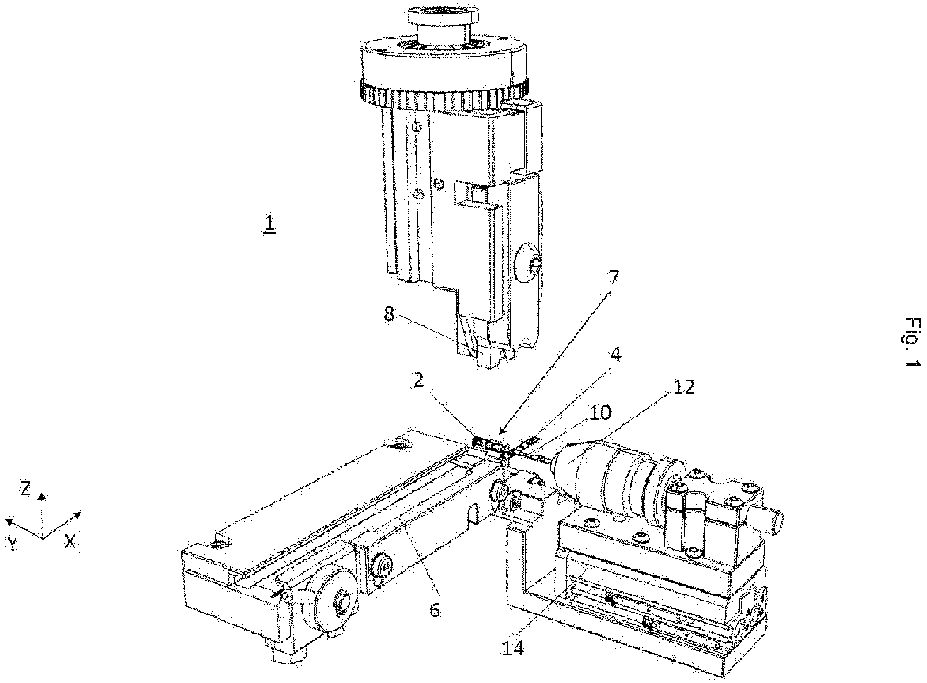

Fig. 1 zeigt eine Ausführungsform einer Vorrichtung 1 zum Prüfen eines Außenleiterkontakts 2. Die gezeigte Vorrichtung 1 weist zumindest eine Führung 6 mit einem Vorschub zum Bereitstellen eines Trägerstreifens 4 mit Außenleiterkontakten 2 an einem Fixierbereich 7 auf. Der Trägerstreifen 4 kann von einem Speicher, wie einer Trägerstreifenrolle, bereitgestellt werden. Der Fixierbereich 7 ist der Bereich an der Vorrichtung 1, an oder in dem ein zu prüfender Außenleiterkontakt 2 fixiert und dann geprüft wird.

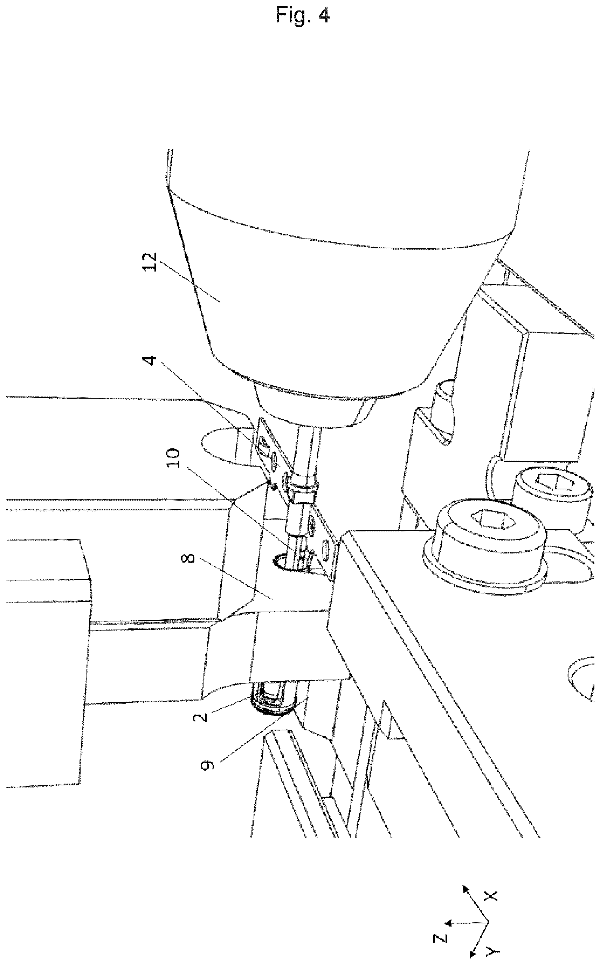

Die Vorrichtung 1 weist weiterhin eine Fixiervorrichtung 8 zum Fixieren eines zu prüfenden Außenleiterkontakts 2 an dem Fixierbereich 7 auf. Die in den Figuren 1 -4 dargestellte Fixiervorrichtung 8 umfasst zumindest einen Niederhalter. Weiterhin kann die Fixiervorrichtung 8 eine Auflage 9 umfassen, auf die der zu prüfende Außenleiterkontakt 2 abgelegt und später fixiert wird. Bevorzugt wird der zu prüfende Außenleiterkontakt 2 beim Fixieren zwischen dem Niederhalter 8 und der Auflage 9 geklemmt. Durch die geklemmte Lagerung ist der zu prüfende Außenleiterkontakt 2 während der Prüfung sicher und bewegungsgehindert gelagert.

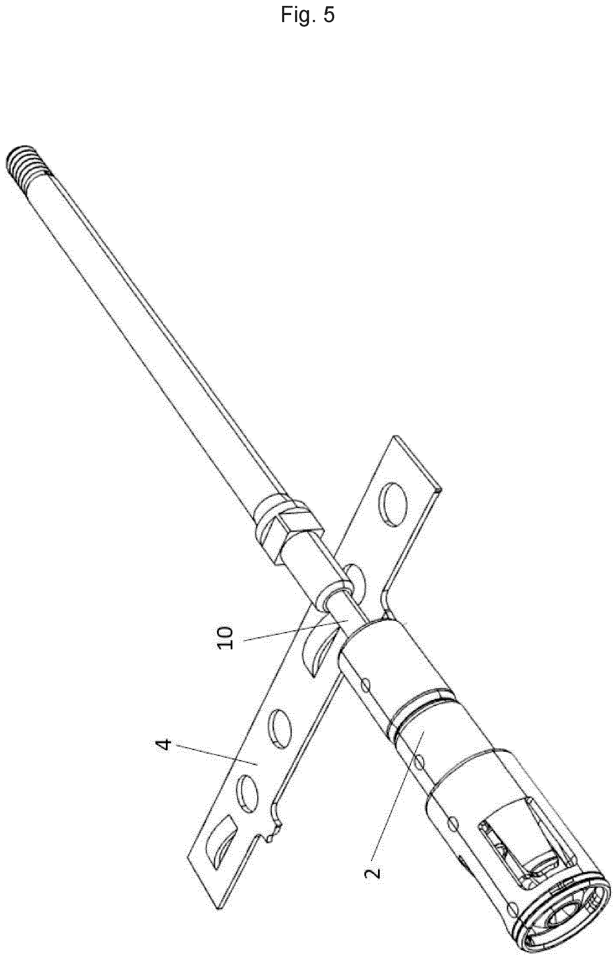

Die Vorrichtung 1 umfasst weiterhin einen Prüfstift 10, der zumindest teilweise in den Außenleiterkontakt 2 eingeführt werden kann (s. Fig. 5). Der in Figs. 1 - 4 dargestellte Prüfstift 10 ist bevorzugt in einer Halterung 12 gelagert und austauschbar. So können je nach zu prüfendem Außenleiterkontakt 2 verschiedene Prüfstifte 10, d.h. insbesondere mit verschiedenen maximalen Durchmessern D1, an der Vorrichtung 1 verwendet werden. Die Halterung 12 ist bevorzugt auf einer verschiebbaren Basis 14 gelagert. Über ein Verschieben der Basis 14 hin und weg von dem Fixierbereich 7 kann der Prüfstift 10, insbesondere mit seiner Prüfspitze 11, an oder in den zu prüfenden Außenleiterkontakt 2 bewegt werden. Die Basis 14 kann zum Beispiel über einen Aktuator bewegt werden.

An den Prüfstift 10 kann eine vorbestimmte Spannung angelegt werden, so dass der Prüfstift 10 ein vorbestimmtes elektrisches Feld erzeugt. Das elektrische Feld wird durch eine Spannung am Prüfstift 10 im Bereich von 100 - 1000 V, bevorzugter im Bereich von 200 - 900 V, noch bevorzugter im Bereich von 300 - 800 V, und am bevorzugtesten im Bereich von 400 - 700 V, erzeugt. Durch das erzeugte elektrische Feld verursachen elektrisch leitfähige Fremdkörper, die sich innerhalb des Außenleiterkontakts 2 befinden, einen Kurzschluss. Diesen Kurzschluss kann man detektieren und erhält somit Rückschluss auf Fremdkörper im Außenleiterkontakt 2. Findet kein Kurzschluss statt, wird der Außenleiterkontakt 2 als "Gutware" klassifiziert und kann weiterverarbeitet werden. Wird ein Kurzschluss detektiert wird der geprüfte Außenleiterkontakt 2 als "Schlechtware" oder Ausschuss klassifiziert und entsprechend markiert und/oder weiterbehandelt. Ein Kurzschluss wird in der Praxis hauptsächlich durch Fremdkörper wie zumindest teilweise gelöste Partikel einer Außenleiterkontaktinnenoberfläche ausgelöst. Die zumindest teilweise gelösten Partikel können Flitter, Späne oder feine Härchen umfassen, die in der Regel noch mit einem Ende an der Innenoberfläche des Außenleiterkontakts verbunden sind.

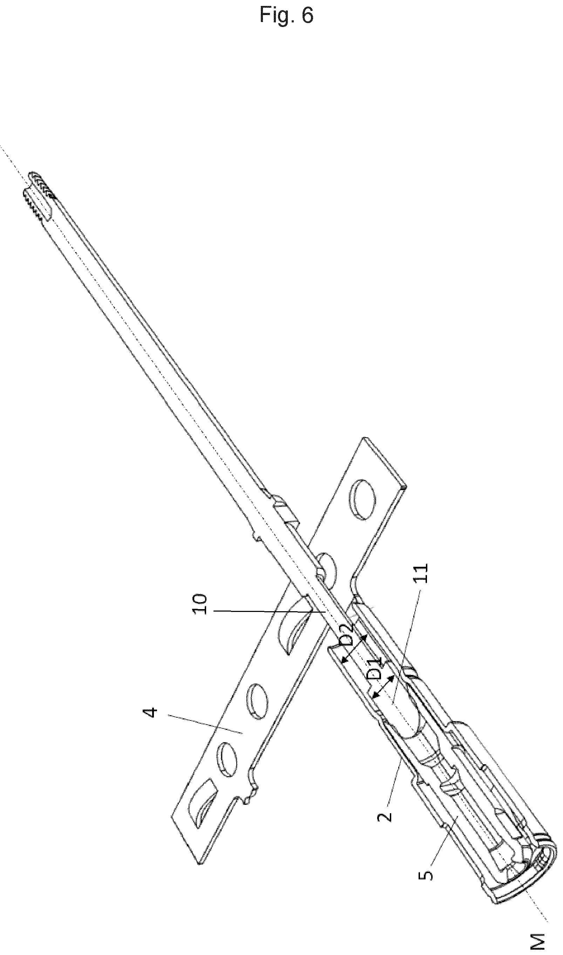

Der Prüfstift 10 weist einen maximalen Durchmesser D1 auf, der insbesondere an der Prüfspitze 11 vorliegt. Der maximale Durchmesser D1 des Prüfstifts 10 ist dabei in Bezug auf den Außenleiterkontakt 2 so gewählt, dass eine Summe aus dem maximalen Durchmesser D1 des Prüfstifts 10 und einer doppelten Mindestluftstrecke kleiner ist als ein Innendurchmesser D2 des Außenleiterkontakts 2 (s. Fig. 6). In der Praxis werden maximale Durchmesser D1 des Prüfstifts 10 im Bereich von 1 - 2 mm, bevorzugt im Bereich von 1,3 - 1,8 mm, verwendet. Die einfache Mindestluftstrecke benennt einen Abstand zum Prüfstift 10, in dem das elektrische Feld so stark wirkt, dass ein elektrischer Körper einen Überschlag oder Kurzschluss zum Prüfstift 10 verursacht. Bildlich gesprochen umgibt die einfache Mindestluftstrecke den Prüfstift 10 wie eine Aura. Im Durchmesser betrachtet man die doppelte Mindestluftstrecke, d.h. jeweils eine einfache Mindestluftstrecke auf beiden Seiten des Prüfstifts 10. Innerhalb dieser Aura, die wie ein vergrößerter Außenumfang des Prüfstift 10 wirkt, wirkt das elektrische Feld des Prüfstifts so stark, dass alle elektrisch leitfähigen Körper, die sich innerhalb der Aura oder Mindestluftstrecke befinden, einen Überschlag oder Kurzschluss erzeugen. Die Mindestluftstrecke wird bevorzugt tabellarisch bei einem vorbestimmten Verschmutzungsgrad ermittelt. In der Praxis kann die Mindestluftstrecke aus der Norm VDE 0110-1/4.97 mit einem Verschmutzungsgrad 1 - 4 tabellarisch ermittelt werden.

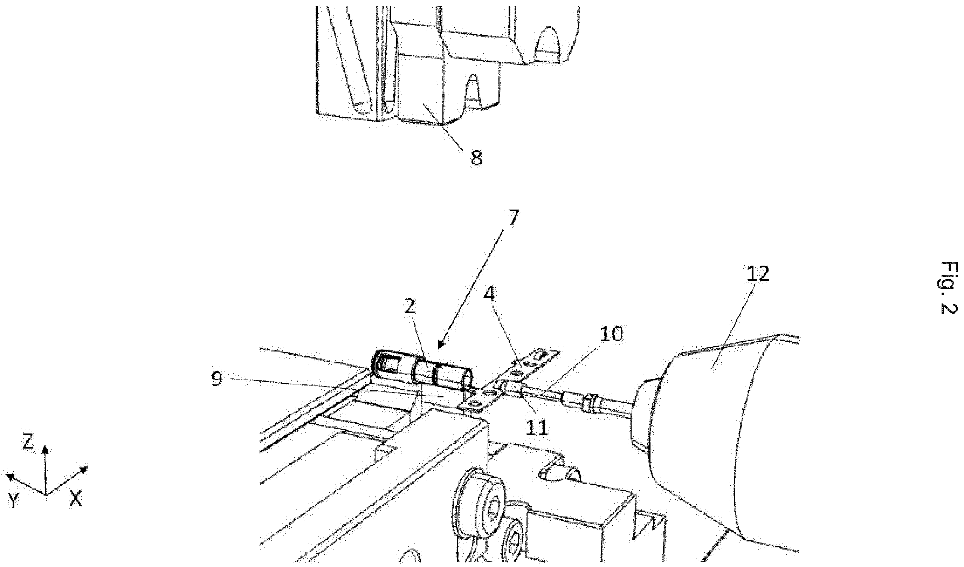

Figuren 2 - 4 zeigen eine Ausführungsform des Verfahrens zum Prüfen eines Außenleiterkontakts 2. Das Verfahren wird bevorzugt vor einer Konfektionierung des Außenleiterkontakts 2 auf eine Leitung durchgeführt. Das Verfahren ist insbesondere für eine automatisierte Prüfung von Außenleiterkontakten 2 geeignet. Das Verfahren weist zumindest die folgenden Schritte auf:

In einem ersten Schritt erfolgt ein Bereitstellen eines zu prüfenden Außenleiterkontakts 2 an dem Fixierbereich 7 (s. Fig. 2). Zum Bereitstellen wird der Trägerstreifen 4 mit Hilfe des Vorschubs und der Führung 6 in einer Vorschubrichtung X bewegt, so dass nacheinander jeder Außenleiterkontakt 2 an dem Trägerstreifen 4 einzeln an dem Fixierbereich 7 angeordnet wird. In der dargestellten Ausführungsform wird der zu prüfende Außenleiterkontakt 2 auf einer Auflage 9 am Fixierbereich 7 abgelegt. Der Prüfstift 10 wird in der Halterung 12 gehalten und ist vom Außenleiterkontakt 2 beabstandet angeordnet.

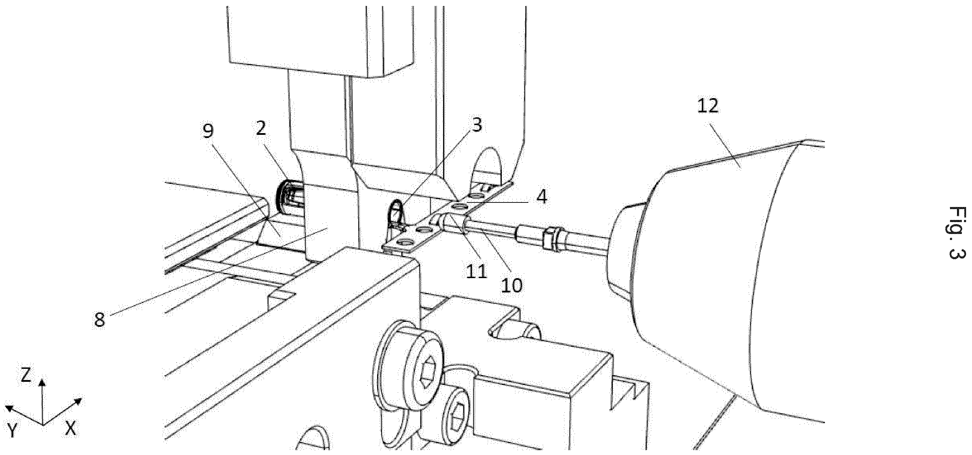

Nach dem Bereitstellen erfolgt ein Fixieren des Außenleiterkontakts 2 an dem Fixierbereich 7. Das Fixieren kann durch Kraft- und/oder Formschluss mit Hilfe einer Fixiervorrichtung 8 erfolgen. Eine Ausführungsform des Fixierens ist in Fig. 3 gezeigt. In dieser Ausführungsform bewegt sich zum Fixieren ein Niederhalter 8 entlang einer dritten Richtung Z zum Außenleiterkontakt 2 und klemmt den Außenleiterkontakt 2 zwischen sich und der Auflage 9 ein. Der Prüfstift 10 ist dabei immer noch beabstandet zum Außenleiterkontakt 2 angeordnet. In einer alternativen Ausführungsform kann der Prüfstift 10 zeitgleich oder zeitversetzt mit der Bewegung des Niederhalters 8 entlang einer zweiten Richtung Y zum Außenleiterkontakt 2 bewegt werden.

Nachdem der zu prüfende Außenleiterkontakt 2 fixiert ist, erfolgt ein Einführen des Prüfstifts 10 zumindest teilweise in den Außenleiterkontakt 2. Das Einführen erfolgt bevorzugt über eine Öffnung 3 am Außenleiterkontakt 2, die sich auf der späteren Kabelabgangsseite befindet, über welche später auch ein Innenleiterkontakt gefügt wird. Später meint dabei in einem nachfolgenden Schritt oder Schritten der Kabelkonfektion. Während des Einführens weist der Prüfstift 10 keine Spannung auf. Obwohl der Außenleiterkontakt 2 mit seiner Mittelachse M in der Praxis so ausgerichtet ist, dass sich der Prüfstift 10 entlang dieser Mittelachse M in oder aus dem Außenleiterkontakt 2 bewegt, wird der Prüfstift 10 dennoch erst unter Spannung gesetzt, wenn der Prüfstift 10 seine Endposition im Außenleiterkontakt 2 erreicht hat, um ungewollte Kurzschlüsse aufgrund einer schiefen Bewegung zu vermeiden. Die Endposition ist frei wählbar. Bevorzugt erfolgt das Einführen des Prüfstifts 10 bis zum Anschlag an einem Isolator 5, der innerhalb des Außenleiterkontakts 2 angeordnet ist (s. Fig. 6). Der Isolator 5 kann vor dem hier beschriebenen Verfahren bereits in dem Außenleiterkontakt 2 angeordnet sein. Der Prüfstift 10 ist bevorzugt federnd in der Halterung 12 gelagert, damit es zu keiner Beschädigung am Außenleiterkontakt 2 und/oder Prüfstift 10 kommt.

Nachdem der Prüfstift 10 in seiner Endposition im Außenleiterkontakt 2 angeordnet ist, erfolgt ein Anlegen einer Spannung an dem Prüfstift 10. Die Spannung umfasst einen vorbestimmten Spannungswert. In Untersuchungen hat sich ergeben, dass die Anzahl an Falschpositiven deutlich gesenkt werden kann, wenn eine geringere Spannung, insbesondere deutlich unter 1000 V, verwendet wird. Angestrebt wird eine Spannung im Bereich von 550 V - 650 V zu verwenden.

Während eine Spannung an dem Prüfstift 10 angelegt wird, erfolgt ein Prüfen, ob ein Kurzschluss zwischen dem Prüfstift 10 und zumindest einem elektrisch leitfähigen Fremdkörper, der sich innerhalb des Außenleiterkontakts 2 befinden kann, stattgefunden hat. Das Prüfen kann dabei durch eine elektrische Messung und/oder eine optische Messung durchgeführt werden. Bei einer elektrischen Messung wird ein Spannungsabfall zwischen dem Prüfstift 10 und dem Außenleiterkontakt 2 anhand einer elektrischen Ableitung detektiert. Für das elektrische Messverfahren müssen Prüfstift 10 und Außenleiterkontakt 2 über Messkontakte mit einer Messvorrichtung verbunden sein. Optional kann anstatt den Außenleiterkontakt 2 mit einem Messkontakt zu verbinden, die Auflage 9, wenn sie aus einem elektrisch leitfähigen Material gebildet ist, mit dem Messkontakt verbunden werden. Unabhängig von dem elektrischen Messverfahren kann ein Kurzschluss auch optisch detektiert werden, da sich beim Kurzschluss ein kurzer Lichtblitz bildet. Mit einer/einem optischen Messvorrichtung/Messverfahren kann ein Lichtblitz innerhalb des Außenleiterkontakts 2 erkannt werden und auf einen Kurzschluss zurückgedeutet werden. Das optische Messverfahren hat gegenüber dem elektrischen Messverfahren den Vorteil, dass es kontaktierungsfrei verwendet wird.

Tritt während des Prüfens ein Kurzschluss auf, so wird der Außenleiterkontakt 2 als Ausschuss deklariert. Dieser Außenleiterkontakt 2 kann dann entsprechend markiert werden und/oder in einem nachfolgenden Bearbeitungsschritt vom Trägerstreifen 4 getrennt werden. Nach der Abtrennung des fehlerhaften Außenleiterkontakts 2 kann der Trägerstreifen 4 abschließend zum Beispiel wieder auf eine Trägerstreifenrolle aufgewickelt werden, wobei der Trägerstreifen 4 dann nur noch als "Gutware" deklarierte Außenleiterkontakte 2 umfasst.

### BEZUGSZEICHENLISTE

- 1: Vorrichtung
- 2: Außenleiterkontakt
- 3: Öffnung
- 4: Trägerstreifen
- 5: Isolator
- 6: Führung
- 7: Fixierbereich
- 8: Fixiervorrichtung
- 9: Auflage
- 10: Prüfstift
- 11: Prüfspitze
- 12: Halterung
- 14: Basis
- D1: maximaler Durchmesser
- D2: Innendurchmesser
- M: Mittelachse
- X: Vorschubrichtung
- Y: zweite Richtung
- Z: dritte Richtung

## Patentansprüche

1. Vorrichtung (1) zum Prüfen eines Außenleiterkontakts (2) aufweisend:
a) eine Führung (6) mit einem Vorschub zum Bereitstellen eines Trägerstreifens (4) mit Außenleiterkontakten (2) an einem Fixierbereich (7);
b) eine Fixiervorrichtung (8) zum Fixieren eines zu prüfenden Außenleiterkontakts (2) an dem Fixierbereich (7);
**gekennzeichnet durch**
c) einen Prüfstift (10), der zumindest teilweise in den Außenleiterkontakt (2) eingeführt werden kann und ausgebildet ist, ein vorbestimmtes elektrisches Feld zu erzeugen, so dass elektrisch leitfähige Fremdkörper, die sich innerhalb des Außenleiterkontakts (2) befinden, einen Kurzschluss verursachen.

2. Vorrichtung (1) nach Anspruch 1, bei dem das elektrische Feld durch eine Spannung am Prüfstift (10) im Bereich von 100 - 1000 V, bevorzugter im Bereich von 200 - 900 V, noch bevorzugter im Bereich von 300 - 800 V, und am bevorzugtesten im Bereich von 400 - 700 V, erzeugt wird.

3. Vorrichtung (1) nach Anspruch 1 oder 2, bei dem ein maximaler Durchmesser (D1) des Prüfstifts (10) in Bezug auf den Außenleiterkontakt (2) so gewählt ist, dass eine Summe aus dem maximalen Durchmesser (D1) des Prüfstifts (10) und einer doppelten Mindestluftstrecke kleiner ist als ein Innendurchmesser (D2) des Außenleiterkontakts (2).

4. Vorrichtung (1) nach Anspruch 3, bei dem die Mindestluftstrecke tabellarisch bei einem vorbestimmten Verschmutzungsgrad ermittelt wird.

5. Vorrichtung (1) nach einem der Ansprüche 1 - 4, bei dem ein Kurzschluss durch Fremdkörper wie zumindest teilweise gelöste Partikel einer Außenleiterkontaktinnenoberfläche ausgelöst wird.

6. Verfahren zum Prüfen eines Außenleiterkontakts (2), wobei das Verfahren die folgenden Schritte aufweist:
a) Bereitstellen eines Außenleiterkontakts (2) an einem Fixierbereich (7);
b) Fixieren des Außenleiterkontakts (2) an dem Fixierbereich (7);
c) Einführen eines Prüfstifts (10) zumindest teilweise in den Außenleiterkontakt (2), wobei der Prüfstift (10) keine Spannung aufweist;
d) Anlegen einer Spannung an dem Prüfstift (10); und
e) Prüfen, ob ein Kurzschluss zwischen dem Prüfstift (10) und zumindest einem elektrisch leitfähigen Fremdkörper, der sich innerhalb des Außenleiterkontakts (2) befinden kann, stattgefunden hat.

7. Verfahren nach Anspruch 6, bei dem das Verfahren vor einer Konfektionierung des Außenleiterkontakts (2) auf einer Leitung stattfindet.

8. Verfahren nach Anspruch 6 oder 7, bei dem das Einführen des Prüfstifts (10) bis zum Anschlag an einem Isolator (5), der innerhalb des Außenleiterkontakts (2) angeordnet ist, durchgeführt wird.

9. Verfahren nach einem der Ansprüche 6 - 8, bei dem das Prüfen durch eine elektrische Messung und/oder eine optische Messung durchgeführt wird.

10. Verfahren nach einem der Ansprüche 6 - 9, bei dem das Fixieren durch Kraft- und/oder Formschluss mit Hilfe einer Fixiervorrichtung (8) erfolgt.

## Claims

1. Apparatus (1) for testing an outer conductor contact (2), comprising:
a) a guide (6) having a feed for providing at a fixing area (7) a carrier strip (4) having outer conductor contacts (2);
b) a fixing apparatus (8) for fixing an outer conductor contact (2) that is to be tested to the fixing area (7); **characterized by**
c) a test pin (10) which can be inserted at least partially into the outer conductor contact (2) and is designed to generate a predetermined electric field so that electrically conductive foreign bodies located within the outer conductor contact (2) cause a short circuit.

2. Apparatus (1) according to Claim 1, in which the electric field is generated by a voltage across the test pin (10) in the range of 100-1000 V, more preferably in the range of 200-900 V, even more preferably in the range of 300-800 V, and most preferably in the range of 400-700 V.

3. Apparatus (1) according to Claim 1 or 2, in which a maximum diameter (D1) of the test pin (10) with respect to the outer conductor contact (2) is selected such that a sum of the maximum diameter (D1) of the test pin (10) and a doubled minimum air gap is smaller than an inner diameter (D2) of the outer conductor contact (2).

4. Apparatus (1) according to Claim 3, in which the minimum air gap is determined tabularly for a predetermined degree of pollution.

5. Apparatus (1) according to one of Claims 1-4, in which a short circuit is caused by foreign bodies such as at least partially dissolved particles on an outer conductor contact inner surface.

6. Method for testing an outer conductor contact (2), wherein the method comprises the following steps:
a) providing an outer conductor contact (2) at a fixing area (7);
b) fixing the outer conductor contact (2) to the fixing area (7);
c) inserting a test pin (10) at least partially into the outer conductor contact (2), wherein the test pin (10) is free of voltage;
d) applying a voltage to the test pin (10); and
e) testing whether a short circuit has occurred between the test pin (10) and at least one electrically conductive foreign body which may be located within the outer conductor contact (2).

7. Method according to Claim 6, in which the method takes place on a line before assembly of the outer conductor contact (2).

8. Method according to Claim 6 or 7, in which the test pin (10) is inserted as far as the stop on an insulator (5) which is arranged within the outer conductor contact (2).

9. Method according to one of Claims 6-8, in which the testing is carried out by an electrical measurement and/or an optical measurement.

10. Method according to one of Claims 6-9, in which the fixing is performed by way of a force-fit and/or form-fit connection with the aid of a fixing apparatus (8).

## Revendications

1. Dispositif (1) de test de contact de conducteur extérieur (2) comportant :
a) un guide (6) présentant une avancée destinée à fournir une bande de support (4) dotée de contacts de conducteur extérieur (2) au niveau d'une zone de fixation (7) ;
b) un dispositif de fixation (8) pour fixer un contact de conducteur extérieur (2) à tester à la zone de fixation (7) ;
**caractérisé par**
c) une broche de test (10) qui peut être introduite au moins partiellement dans le contact de conducteur extérieur (2) et qui est conçue pour générer un champ électrique prédéterminé, de sorte que des corps étrangers électriquement conducteurs présents à l'intérieur du contact de conducteur extérieur (2) provoquent un court-circuit.

2. Dispositif (1) selon la revendication 1, dans lequel le champ électrique est généré par une tension sur la broche de test (10) dans la plage de 100 à 1000 V, de préférence de 200 à 900 V, plus préférentiellement de 300 à 800 V, et le plus préférentiellement de 400 à 700 V.

3. Dispositif (1) selon la revendication 1 ou 2, dans lequel un diamètre maximal (D1) de la broche de test (10) par rapport au contact de conducteur extérieur (2) est choisi de sorte qu'une somme du diamètre maximal (D1) de la broche de test (10) et d'une double distance minimale dans l'air soit inférieure à un diamètre intérieur (D2) du contact de conducteur extérieur (2).

4. Dispositif (1) selon la revendication 3, dans lequel la distance minimale dans l'air est déterminée à partir de tableaux pour un degré de contamination prédéterminé.

5. Dispositif (1) selon l'une des revendications 1 à 4, dans lequel un court-circuit est déclenché par des corps étrangers tels que des particules au moins partiellement détachées d'une surface intérieure du contact de conducteur extérieur.

6. Procédé de test d'un contact de conducteur extérieur (2), le procédé comprenant les étapes suivantes :
a) fournir un contact de conducteur extérieur (2) au niveau d'une zone de fixation (7) ;
b) fixer le contact de conducteur extérieur (2) à la zone de fixation (7) ;
c) introduire une broche de test (10) au moins partiellement dans le contact de conducteur extérieur (2), la broche de test (10) n'étant pas sous tension ;
d) appliquer une tension à la broche de test (10) ; et
e) vérifier si un court-circuit s'est produit entre la broche de test (10) et au moins un corps étranger électriquement conducteur qui peut se trouver à l'intérieur du contact de conducteur extérieur (2).

7. Procédé selon la revendication 6, dans lequel le procédé est mis en œuvre avant qu'une confection du contact de conducteur extérieur (2) sur une ligne se produise.

8. Procédé selon la revendication 6 ou 7, dans lequel l'introduction de la broche de test (10) est effectuée jusqu'à la butée contre un isolant (5) disposé à l'intérieur du contact de conducteur extérieur (2).

9. Procédé selon l'une des revendications 6 à 8, dans lequel le test est est effectué par une mesure électrique et/ou une mesure optique.

10. Procédé selon l'une des revendications 6 à 9, dans lequel la fixation est effectuée par complémentarité de force et/ou de forme à l'aide d'un dispositif de fixation (8).
